Europäisches Patentamt

European Patent Office

Office européen des brevets

(19)

(11) Veröffentlichungsnummer : **0 052 747**
**B2**

(12) # NEUE EUROPÄISCHE PATENTSCHRIFT

(45) Veröffentlichungstag der neuen Patentschrift :
23.11.89

(51) Int. Cl.⁴ : **H 05 K   7/20**, H 05 K   5/00

(21) Anmeldenummer : 81108392.2

(22) Anmeldetag : 16.10.81

(54) Gehäuse zur Aufnahme von mit Wärme erzeugenden elektronischen Bauteilen bestückten gedruckten Schaltungen.

(30) Priorität : 25.11.80 DE 3044314

(43) Veröffentlichungstag der Anmeldung :
02.06.82 Patentblatt 82/22

(45) Bekanntmachung des Hinweises auf die Patenterteilung : 27.03.85 Patentblatt 85/13

(45) Bekanntmachung des Hinweises auf die Entscheidung
über den Einspruch : 23.11.89 Patentblatt 89/47

(84) Benannte Vertragsstaaten :
AT CH FR GB IT LI SE

(56) Entgegenhaltungen :
DE—A— 2 740 772
DE—C— 2 226 057
FR—A— 1 393 570
US—A— 3 268 772
US—A— 3 904 933
US—A— 3 956 673
US—A— 4 006 388

(73) Patentinhaber : KABELMETAL ELECTRO GMBH
Kabelkamp 20 Postfach 260
D-3000 Hannover 1 (DE)

(72) Erfinder : Still, Michael, Dipl.-Ing.
Heinkenstrasse 10
D-3012 Langenhagen (DE)
Erfinder : Baum, Walter, Dipl.-Phys.
Wedemeyerstrasse 9
D-3000 Hannover (DE)
Erfinder : Becker, Erich, Ing.grad.
Albert-Schweizer-Strasse 5B
D-6104 Seeheim-Jugenheim 1 (DE)

EP 0 052 747 B2

## Beschreibung

Die Erfindung betrifft ein Gehäuse zur Aufnahme von Wärme erzeugenden elektronischen Bauteilen, welche innerhalb des Gehäuses angeordnet sind, wobei das Gehäuse eine gasdicht abgeschlossene Einheit bildet und die von den Bauteilen erzeugte Wärme durch Wärmerohre aus dem Innern des Gehäuses abführbar ist.

Aus der FR-A-1 393 510 ist ein hermetisch nach außen abgeschlossenes Gehäuse bekannt, in dessen Innern elektrische und elektronische Bauteile angeordnet sind. Um die von den Bauteilen erzeugte Wärme aus dem Innenraum des Gehäuses herauszuführen, ist eine der Wandungen des Gehäuses von Wärmerohren durchsetzt, welche die Wärme aus dem Gehäuse herausführen. Wärmerohre sind Wärmetransporteinrichtungen, welche aus einem Rohr bestehen, das endseitig verschlossen ist und dessen Innenraum evakuiert und mit einem flüssigen Arbeitsmittel gefüllt ist. Wird einem Wärmerohr an einem Ende (Heizzone) Wärme zugeführt, so verdampft das dort befindliche Arbeitsmittel und kondensiert am kälteren Ende (Kühlzone). Bei Wärmerohren findet also ein Wärmetransport mittels der Verdampfungswärme statt.

Bei der FR-A-1 393 510 ist über die Anordnung der wärmeabgebenden Bauteile nichts ausgesagt.

In der digitalen Fernsprechvermittlung, bei der Steuerung von Rolltreppen, als Zentraleinheit eines Elektronenrechners, werden gedruckte Schaltungen verwendet, welche mit den Bauelementen bestückt sind. Die Schaltungen sind in Gehäusen untergebracht.

Der Nachteil dieser Vorgehensweise ist darin zu sehen, daß das Innere des Gehäuses durch die von den elektronischen Bauteilen abgegebene Verlustwärme aufgewärmt und die Lebensdauer der elektronischen Bauteile wesentlich verkürzt wird. Aus diesem Grunde war man bisher gezwungen, die Packungsdichte und die Anordnung der gedruckten Schaltungen nach kühltechnischen Gesichtspunkten festzulegen. Daraus resultierte ein hoher räumlicher Aufwand für die gedruckten Schaltungen.

Der vorliegenden Erfindung liegt die Aufgabe zugrunde, die bekannten Gehäuse dahingehend zu verbessern, daß mit ihnen eine höhere Packungsdichte und eine elektrisch günstige Anordnung der elektronischen Bauteile ohne großen technischen Aufwand möglich ist, daß die von den elektronischen Bauelementen erzeugte Verlustwärme in einfacher Weise aus dem Gehäuseinnern heraustransportiert werden kann, und dadurch die Betriebstemperatur der Bauelemente herabgesenkt und die Lebensdauer der Bauelemente verlängert werden kann.

Diese Aufgabe wird dadurch gelöst, daß die Bauteile auf bestückten gedruckten Schaltungen in Kartenform mit Frontplatte und Steckverbinder aufsitzen, wobei die Karten auswechselbar in einem Steckrahmen angeordnet sind und daß die oben gelegene Wandung des Gehäuses aus einer Metallplatte besteht, welche mindestens ein Wärmerohr enthält.

Die Kühlung des Gehäuseinneren über die Metallplatte und das Wärmerohr ermöglicht höhere Packungsdichten, ohne daß die Temperatur im Innern des Gehäuses in unzulässiger Weise erhöht wird. Die von den Bauelementen erzeugte Verlustwärme steigt im Innern des Gehäuses nach oben, erwärmt das in dem Wärmerohr befindliche Arbeitsmedium und bringt dieses zum Verdampfen. Der Dampf strömt dann in an sich bekannter Weise zum gekühlten Ende des Wärmerohres und kondensiert dort. Nach einer besonders vorteilhaften Ausgestaltung der Erfindung sind die Gehäuse stapelbar ausgebildet. Die modulare Bauweise ermöglicht insbesondere ein leichtes Auswechseln, beispielsweise defekter Gehäuse, sowie eine einfache Vergrößerung der Anlage, indem ein neues Gehäuse hinzugefügt wird. Nach einer ebenfalls vorteilhaften Ausgestaltung der Erfindung weist das Gehäuse mehrere vorzugsweise übereinander angeordnete Öffnungen auf, in welche die mit den elektronischen Bauteilen bestückten Einschübe einschiebbar sind und sind die Öffnungen gasdicht verschließbar. Beim Auswechseln zum Beispiel defekter Einschübe wird eine Frontplatte gelöst, der defekte Einschub herausgenommen, ein neuer Einschub eingesetzt, elektrisch und wärmetechnisch angeschlossen und die Frontplatte vorgesetzt. Das Gehäuse ist mit den Wärmerohren vorkonfektioniert. Befindet sich auf der Karte ein mit großen Wärmeverlusten behaftetes elektronisches Bauelement, wie zum Beispiel ein Leistungstransistor, Thyristor oder ein Laser, ist es zweckmäßig, für jede einsteckbare Karte ein gesondertes Wärmerohr vorzusehen, dessen eines Ende lösbar an ein auf der Karte angeordnetes mit dem Bauelement verbundenes Wärmerohr anschließbar und dessen anderes Ende in gut wärmeleitendem Kontakt an der Metallplatte angebracht ist. Die beiden Wärmerohre transportieren die durch das elektronische Bauteil erzeugte Verlustwärme unmittelbar an die Metallplatte, so daß diese Bauteile die Atmosphäre im Innern des Gehäuses nur unwesentlich erwärmen. Die Metallplatte weist zweckmäßigerweise mindestens zwei in die Metallplatte nahtlos integrierte parallel zueinander verlaufende endseitig vakuumdicht verschlossene Kanäle auf, die als Wärmerohre fungieren. Dadurch, daß die Kanäle in dem Metallblech integriert sind, ergibt sich ein optimaler Wärmeübergang von der Metallplatte auf das in den Kanälen befindliche Arbeitsfluid. Je nach abzuführender Wärmemenge kann man die Anzahl der Kanäle und damit der Wärmerohre erhöhen. Nach einer besonders vorteilhaften Ausgestaltung der Erfindung ist auf zwei gegenüberliegenden lotrechten Wandungen des Gehäuses ein Rechteckprofil aus Kupfer angebracht, die Metallplatte in horizontaler Richtung geneigt zwischen den Rechteckprofilen befestigt und zumindest das auf einem örtlich höheren Niveau gelegene Ende der Metallplatte in das Rechteckprofil eingelassen. Die Neigung der Metallplatte ermöglicht, daß das Kondensat im Wärmerohr aufgrund der Schwerkraft zum tiefergelegenen Ende zurückströmen kann. Die Rechteckprofile dienen als Auflager für die Gehäuse, sofern die Gehäuse gestapelt werden sollen. Dadurch, daß das auf einem örtlich höheren Niveau gelegene Ende der Metallplatte in das Rechteckprofil eingelassen ist, ergibt sich ein guter Wärmekontakt zum gekühlten Rechteckprofil, welcher die Wirksamkeit der Wärmerohre erhöht. In eine Wandung des Gehäuses, vorzugsweise im Boden, ist eine elektrisch beheizbare Folie eingearbeitet. Diese heizbare Folie dient dazu, die Atmosphäre innerhalb des Gehäuses vor Inbetriebnahme vorzuheizen, wenn die Außentemperatur den Betriebsbereich der elektronischen Bauelemente unterschreitet. Mit besonderem Vorteil ist das Gehäuse während des Betriebes mit einem Schutzgas, wie zum Beispiel Argon, gefüllt. Dadurch wird die Oxidation der elektronischen Bauelemente verhindert und somit die Lebensdauer dieser Elemente wesentlich erhöht. An dem Rechteckprofil, an dem das auf einem örtlich höheren Niveau gelegene Ende der Metallplatte endet, sind Anschlußmöglichkeiten für mindestens ein Wärmerohr vorgesehen. Dieses Wärmerohr ist mit seinem anderen Ende an eine Kühlsammelschiene angeschlossen und transportiert die von den in der Metallplatte integrierten Wärmerohren auf das Rechteckprofil transferierte Wärme in die Kühlsammelschiene, welche die Wärme wiederum aus dem Raum heraustransportiert. Das zwischen der Karte und der Metallplatte angeordnete Wärmerohr weist ein elektrisch isolierendes Übergangsteil auf. Diese Maßnahme ist dann von Vorteil, wenn das elektronische Bauelement auf einem höheren elektrischen Potential steht als das Gehäuse. Mit besonderem Vorteil ist an mindestens einer Übergangsstelle eines Wärmerohres ein Peltier-Element zwischengeschaltet. Dieses Peltier-Element bewirkt, daß durch schlechten Wärmeübergang aufgetretene Temperaturgefälle ausgeglichen werden.

Die Kühlsammelschiene ist zweckmäßigerweise als Hohlprofil ausgebildet, welches von einem Kühlmittel durchströmt ist, welchem wiederum die aufgenommene Wärmemenge durch einen Wärmepumpenprozeß entziehbar ist. Die von den elektronischen Bauelementen erzeugte Verlustwärme kann somit zu Heizungszwecken genutzt werden.

Einen besonders günstigen Abtransport der Wärme erreicht man, wenn man die Rechteckprofile als Doppellochprofile ausbildet, die Kanäle des Dachteiles in die Hohlräume des Doppellochprofils münden läßt und wenn die Kanäle gemeinsam mit den Hohlräumen ein Wärmerohrsystem bilden.

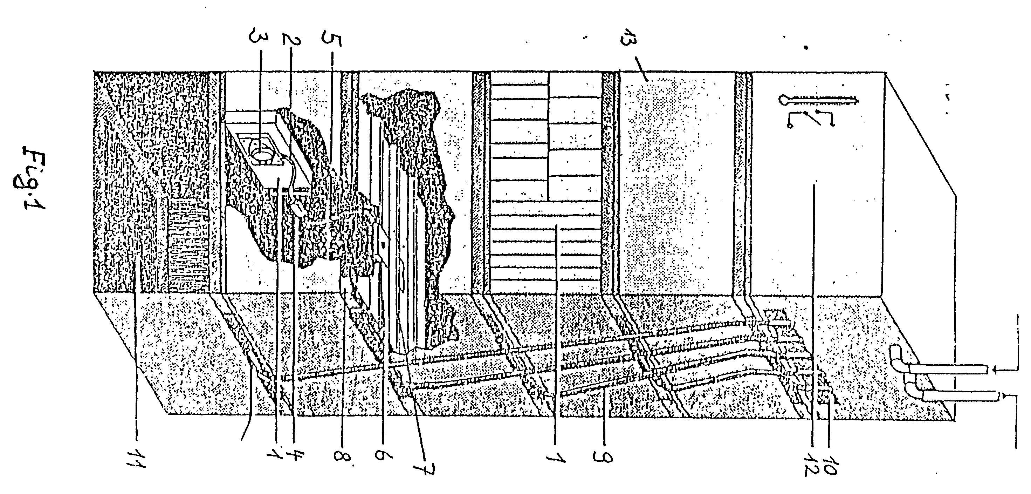

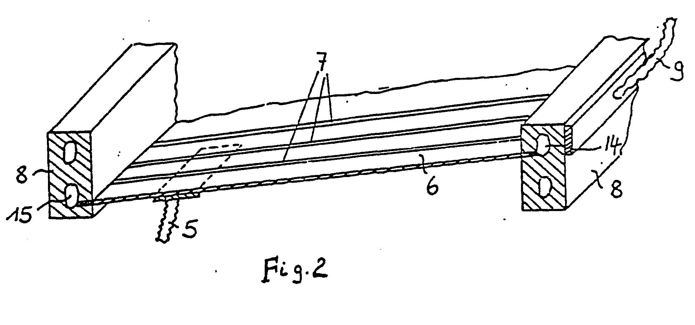

Die Erfindung ist anhand der in den Fig. 1 und 2 schematisch dargestellten Ausführungsbeispiele näher erläutert.

In der Fig. 1 ist ein Stapel dargestellt, der aus mehreren Gehäusen besteht, die im Prinzip gleichartig ausgebildet sind. Jedes Gehäuse ist in sich mechanisch stabil, so daß es, wie dargestellt, stapelbar ist. In jedem Gehäuse sind die Elektronikeinheiten 1, zum Beispiel Doppeleuropakarten, einsteckbar angeordnet. Auf der Elektronikeinheit 1 ist ein Wärmerohr 2 angebracht, welches die Wärme von dem Wärme erzeugenden Element, beispielsweise einem Leistungstransistor 3, abtransportiert. Das dem Transistor 3 abgekehrte Ende des Wärmerohres 2 endet in einer Steckverbindung 4, die das Wärmerohr 2 mit einem weiteren Wärmerohr 5 lösbar verbindet. Das der Steckverbindung 4 abgekehrte Ende des Wärmerohres 5 ist am Dachteil 6 des Gehäuses wärmeleitend angebracht. Das Dachteil 6 weist mehrere Kanäle 7 auf, die gemeinsam ein in sich geschlossenes Wärmerohrsystem bilden. Die einzelnen Wärmerohre 7 transportieren die von den Wärmerohren 2 und 5 herangeführte sowie die innerhalb des Gehäuses aufsteigende Wärme zu einem Profil 8, von dem die Wärme über eine Vielzahl von Wärmerohren 9 zu einer Kühlsammelschiene 10 transportiert wird. Am Boden eines jeden Gehäuses ist eine elektrisch beheizbare Folie 11 angeordnet, die über einen Thermoschalter für eine Beheizung sorgt, sobald die Temperatur innerhalb des Gehäuses geringer ist als die zulässige Betriebstemperatur. Diese Anordnung ist nötig, bei Verwendung der erfindungsgemäßen Anordnung in ungeheizten Räumen, um Minustemperaturen, die zur Zinnpest führen können, zu verhindern. Als oberste Einheit wird eine Wärmepumpe 12 verwendet. Diese Wärmepumpe 12 steuert die Kühlsammelschiene 10 in Abhängigkeit von der Raumtemperatur bis vor den Taupunkt herab. Damit ist gewährleistet, daß sich im System nirgendwo Kondenswasser bilden kann und daß die Betriebstemperatur so niedrig wie möglich gefahren wird. Bei Raumtemperaturen, zum Beispiel unter 20 °C wird diese Steuerung unterbrochen, damit auch ein Arbeiten in unbeheizten Räumen möglich ist. Die Wärmepumpeneinheit 12 selbst speist ihre abgegebene Wärme in einen Wasserkreislauf, der zu Heizzwecken oder anderer Nutzwärme gebraucht werden kann. In größeren Einheiten ist es möglich, auf die Wärmepumpeneinheit je Stapel zu verzichten und für eine ganze Gehäusestapelreihe eine große Kühlsammelschiene vorzusehen, die wiederum an eine größere Wärmepumpeneinheit angeschlossen ist.

Die Fig. 2 zeigt das Dachteil des Gehäuses in vergrößerter Darstellung. Auf den seitlichen Stützwänden der Gehäuse sitzen Hohlprofile 8, in welche ein Kupferblech 6 eingelassen sind. Dieses Kupferblech 6 weist mehrere parallel zueinander verlaufende Kanäle 7 auf, die nach einem speziellen Verfahren hergestellt sind. Die Kanäle 7 münden endseitig im Hohlraum 14 bzw. 15 des Profils 8 und bilden ein Wärmerohrsystem. Eine leichte Neigung des Kupferbleches 6 dient dazu, den Kondensattransport zum wärmeaufnehmenden Teil des Kupferbleches 6 (linke Hälfte der Figur) zu beschleunigen. Dem gleichen Zweck dient eine im Innern der Kanäle 7 angeordnete nicht näher bezeichnete Kapillarschicht.

Jedes Gehäuse ist zweckmäßigerweise eine in sich geschlossene Einheit, die leicht ausgewechselt werden kann, indem das Wärmerohr 9 von dem Profil 8 gelöst wird. Im Innern der Gehäuse herrscht eine Schutzgasatmosphäre, so daß eine Oxidation der Bauelemente verhindert wird und so die Lebensdauer vergrößert wird.

Die erfindungsgemäße Anordnung weist eine Reihe von Vorteilen auf :

Anstelle des bisherigen Gestelleinbaus, der langwierige Hochbaumaßnahmen erfordert, werden die erfindungsgemäßen Gehäuse als Einschubkästen im Doppeleuropaformat vorgesehen. Die Gehäuse sind bis zu einer Höhe von 2,60 m stapelbar und können sowohl Rücken an Rücken als auch an einer Wand aufgestellt werden. Die Gehäuse sind alle mit einer luftdichten Frontplatte 13 versehen, so daß im Innern der Gehäuse eine Schutzgasatmosphäre aufrechterhalten werden kann. Mit dem Einbau einer automatischen Wärmeabführung in die elektronischen Geräte selbst ist ein Aufstellen in nicht klimatisierten Räumen möglich. Die erfindungsgemäße Anordnung erlaubt eine wesentlich größere Packungsdichte, da die entstehende Wärme entweder durch die Wärmerohre 2 und 5 oder aber durch das Dachteil 6 selbsttätig abgeführt wird. Wesentlich ist ferner, daß mit dieser Technik die Bauteile dort angeordnet werden können, wo sie elektronisch am günstigsten sitzen. Man muß sich nicht mehr durch lange Zuführungen einen kühlen Platz an der Gehäuseperipherie erkaufen.

## Patentansprüche

1. Gehäuse zur Aufnahme von Wärme erzeugenden elektronischen Bauteilen, welche innerhalb des Gehäuses angeordnet sind, wobei das Gehäuse eine gasdicht abgeschlossene Einheit bildet und die von den Bauteilen erzeugte Wärme durch Wärmerohre aus dem Innern des Gehäuses abführbar ist, dadurch gekennzeichnet, daß die Bauteile auf bestückten gedruckten Schaltungen in Kartenform mit Frontplatte und Steckverbinder aufsitzen, wobei die Karten auswechselbar in einem Steckrahmen angeordnet sind und daß die oben gelegene Wandung des Gehäuses aus einer Metallplatte besteht, welche mindestens ein Wärmerohr enthält.

2. Gehäuse nach Anspruch 1, dadurch gekennzeichnet, daß das Gehäuse stapelbar ist.

3. Gehäuse nach Anspruch 1 oder 2, dadurch gekennzeichnet, daß das Gehäuse mehrere vorzugsweise übereinander angeordnete Öffnungen aufweist, in welche die mit den elektronischen Bauteilen bestückten Einschübe einschiebbar sind.

4. Gehäuse nach Anspruch 1 oder einem der folgenden, dadurch gekennzeichnet, daß für jede einsteckbare Karte ein gesondertes Wärmerohr vorgesehen ist, dessen eines Ende lösbar an ein auf der Karte angeordnetes Wärmerohr anschließbar und dessen anderes Ende in gut wärmeleitendem Kontakt an der Metallplatte angebracht ist.

5. Gehäuse nach Anspruch 1 oder einem der folgenden, dadurch gekennzeichnet, daß die Metallplatte mindestens zwei in die Metallplatte nahtlos integrierte parallel zueinander verlaufende endseitig vakuumdicht verschlossene Kanäle aufweist, die als Wärmerohre fungieren.

6. Gehäuse nach Anspruch 1 oder einem der folgenden, dadurch gekennzeichnet, daß auf zwei gegenüberliegenden lotrechten Wandungen des Gehäuses ein Rechteckprofil aus Kupfer angebracht ist, daß die Metallplatte in horizontaler Richtung geneigt zwischen den Rechteckprofilen befestigt ist und zumindest das auf einem örtlich höheren Niveau gelegene Ende der Metallplatte in das Rechteckprofil eingelassen ist.

7. Gehäuse nach Anspruch 1 oder einem der folgenden, dadurch gekennzeichnet, daß in eine Wandung vorzugsweise im Boden eine elektrisch beheizbare Folie eingearbeitet ist.

8. Gehäuse nach Anspruch 1 oder einem der folgenden, dadurch gekennzeichnet, daß das Gehäuse mit einem Schutzgas, wie zum Beispiel Argon, gefüllt ist.

9. Gehäuse nach Anspruch 6, dadurch gekennzeichnet, daß an dem Rechteckprofil, an dem das auf einem örtlich höheren Niveau gelegene Ende der Metallplatte endet, Anschlußmöglichkeiten für mindestens ein Wärmerohr vorgesehen sind und daß dieses Wärmerohr an eine Kühlsammelschiene angeschlossen ist.

10. Gehäuse nach Anspruch 4, dadurch gekennzeichnet, daß das zwischen der Karte und der Metallplatte angeordnete Wärmerohr ein elektrisch isolierendes Übergangsteil aufweist.

11. Gehäuse nach Anspruch 4 oder einem der folgenden, dadurch gekennzeichnet, daß an mindestens einer Übergangsstelle eines Wärmerohres ein Peltier-Element zwischengeschaltet ist.

12. Gehäuse nach Anspruch 9, dadurch gekennzeichnet, daß die Kühlsammelschiene als Hohlprofil ausgebildet ist, welches von einem Kühlmittel durchströmt ist, welchem die aufgenommene Wärmemenge durch einen Wärmepumpenprozeß entziehbar ist.

13. Gehäuse nach Anspruch 6 oder einem der folgenden, dadurch gekennzeichnet, daß die Rechteckprofile als Doppellochprofile ausgebildet sind, daß die Kanäle des Dachteils in die Hohlräume des Doppellochprofils münden und die Kanäle gemeinsam mit den Hohlräumen ein Wärmerohrsystem bilden.

## Claims

1. Housing for accommodating heat-generating electronic components which components are arranged inside the housing, the housing forming a unit which is sealed to be gas tight and the heat generated by the components is transferred from the inside of the housing to the outside by heat-pipes, characterized in that the components are positioned on printed circuits in card form, provided with front panel and plug connector which circuits are arranged to be exchangeable in a plug-in frame and that the top wall of the housing consists of a metal plate which is provided with at least one duct and that this duct is constructed as a heat pipe.

2. Housing according to claim 1, characterized in that the housing is adapted to be stacked.

3. Housing according to claim 1, characterized in that the housing has several openings which are preferably arranged above each other and into which the plug-ends fitted with the electronic components can be inserted.

4. Housing according to claim 1 or one of the subsequent claims, characterized in that for each card which can be plugged in a separate heat pipe is provided one end of which can be connected in a manner so as to be releasable to a heat pipe arranged on the card and the other end of which is mounted in good heat-conductive contact on the metal plate.

5. Housing according to claim 1 or one of the subsequent claims, characterized in that the metal plate is provided with at least two ducts which are parallel with each other and are seamlessly integrated into the metal plate and the ends of which ducts are closed to be vacuum tight and which ducts are filled with a working fluid in an accurately regulated manner.

6. Housing according to claim 1 or one of the subsequent claims, characterized in that at two opposite perpendicular walls of the housing, a rectangular copper section is attached, that the metal plate is mounted in the horizontal direction inclined between the rectangular sections and at least the end, which is at a locally higher level, of the metal plate is let into the rectangular section.

7. Housing according to claim 1 or one of the subsequent claims, characterized in that an electrically heatable foil is worked into one wall and preferably into the bottom.

8. Housing according to claim 1 or one of the subsequent claims, characterized in that the housing is filled with a protective gas such as, for example, argon.

9. Housing according to claim 1 or one of the subsequent claims, characterized in that at the rectangular section at which the end, which is at a locally higher level of the metal plate ends, connection facilities are provided for at least one heat pipe and that this heat pipe is connected to a cooling bus bar.

10. Housing according to claim 1 or one of the subsequent claims, characterized in that the heat pipe installed between the card and the metal plate is provided with an electrically insulating transition part.

11. Housing according to claim 1 or one of the subsequent claims, characterized in that a Peltier element is interposed at at least one transition point of a heat pipe.

12. Housing according to claim 1 or one of the subsequent claims, characterized in that the cooling bus bar is constructed as a hollow section through which a coolant flows from which the quantity of heat absorbed can be removed by a heat-pump process.

13. Housing according to claim 1 or one of the subsequent claims, characterized in that the rectangular sections are constructed as double-hole hollow sections, that the ducts of the roof part open up into the hollow spaces of the double-hole section and the ducts, in conjunction with the hollow spaces, form a heat-pipe system.

## Revendications

1. Armoire pour des composants électroniques dégageant de la chaleur qui sont disposés à l'intérieur de l'armoire, qu'elle forme une unité fermée, étanche aux gaz et de qu'elle la chaleur est transportée par des tubes de transmission de chaleur caractérisée en ce que les panneaux de circuits imprimés en forme de coffrets sont munis de composants avec une plaque frontale et un connecteur à enfichage, qui sont disposés interchangeables dans un cadre d'insertion et que la paroi située en haut est constituée par une plaque de métal laquelle comporte au moins un canal et que ce dernier est réalisé sous la forme d'un tube de transmission de chaleur.

2. Armoire suivant la revendication 1, caractérisée en ce qu'elle est empilable.

3. Armoire suivant la revendication 1, caractérisée en ce qu'elle présente plusieurs ouvertures, disposées notamment les unes au-dessus des autres, dans lesquelles les coffrets ou tiroirs garnis de composants électroniques peuvent être insérés par glissement.

4. Armoire suivant l'une quelconque des revendications 1 à 3, caractérisée en ce que pour chaque coffret à insérer, est prévu un tube de transmission de chaleur particulier dont une extrémité peut être raccordée, de manière détachable, à un tube de transmission de chaleur disposé sur le coffret et dont l'autre extrémité est en contact de bonne transmission de chaleur avec la plaque de métal.

5. Armoire suivant l'une quelconque des revendications 1 à 4, caractérisée en ce que la plaque de métal comporte au moins deux canaux parallèles entre eux, intégrés sans soudure dans la plaque, dont les extrémités sont fermées de manière étanche au vide et qui sont remplis de manière exactement dosée avec un fluide de travail.

6. Armoire suivant l'une quelconque des revendications 1 à 5, caractérisée en ce que, sur deux parois horizontales se faisant face de l'armoire, est monté un profilé rectangulaire en cuivre, la plaque de métal étant fixée inclinée sur l'horizontale entre ces profilés, au moins l'extrémité de la plaque située au niveau le plus élevé engagée dans le profilé rectangulaire.

7. Armoire suivant l'une quelconque des revendications 1 à 6, caractérisée en ce que l'une des parois, notamment le fond, est constituée par une feuille ou un film à chauffage électrique.

8. Armoire suivant l'une quelconque des revendications 1 à 7, caractérisée en ce qu'elle est remplie avec un gaz protecteur, par exemple de l'argon.

9. Armoire suivant l'une quelconque des revendications 1 à 8, caractérisée en ce que, sur le profilé rectangulaire sur lequel se termine l'extrémité de la plaque métallique qui se trouve au niveau le plus élevé, sont prévues des possibilités de raccordement pour au moins un tube de transmission de chaleur lequel est raccordé à un profilé collecteur de refroidissement.

10. Armoire suivant l'une quelconque des revendications 1 à 9, caractérisée en ce que, le tube de transmission de chaleur qui est disposé entre le coffret et la plaque de métal comporte une partie de transition isolée électriquement.

11. Armoire suivant l'une quelconque des revendications 1 à 10, caractérisée en ce que, sur au moins un emplacement de transition d'un tube de transmission de chaleur est intercalé et connecté un élément de PELTIER.

12. Armoire suivant l'une quelconque des revendications 1 à 11, caractérisée en ce que le profilé collecteur de refroidissement est constitué par un profilé creux où circule un fluide de refroidissement duquel la chaleur absorbée peut être extraite par une opération de pompage de chaleur.

13. Armoire suivant l'une quelconque des revendications 1 à 12, caractérisée en ce que les profilés rectangulaires sont constitués par des profilés creux à deux perforations, les canaux de la partie de toit débouchant dans les espaces vides du profilé creux à double perforation, et formant, en commun avec des espaces un système de tube de transmission de chaleur.

Fig.1

Fig.2